# EUROPEAN PATENT APPLICATION

(11) **EP 4 183 740 A1**
(43) Date of publication of application: **24.05.2023**
(21) Application number: 21758722.9
(22) Date of filing: 20.07.2021
(51) Int. Cl.: B82Y 30/00, B82Y 40/00

(54) **PROCESS FOR THE OBTAINMENT OF SUSPENDED DOUBLE-FLAT SU-8 JANUS CHIPS, SAID SUSPENDED DOUBLE-FLAT SU-8 JANUS CHIPS AND SUSPENDED ARRAY THEREOF**

(30) Priority: 20.07.2020 ES 202030756
(71) Applicant: Consejo Superior de Investigaciones Científicas (CSIC), 28006 Madrid (ES)
(72) Inventor: PLAZA PLAZA, Jose Antonio, 08193 Cerdanyola del Vallès - Bellaterra ( Barcelona) (ES); AGUSIL ANTONOFF, Juan Pablo, 08193 Cerdanyola del Vallès - Bellaterra ( Barcelona) (ES)
(74) Representative: Pons
(86) International application number: PCT/ES2021/070539
(87) International publication number: WO 2022/018314

(57) **Abstract**

The invention relates to a process for the obtainment of suspended double-flat SU-8 Janus chips by means of SU-8 photolithography to create an arrangement of ordered SU-8 chips on a substrate and soft lithography to create a planar printed arrangement or a planar printed array on each chip, said process comprising steps for forming a solidified membrane that is peeled off and dissolved in an aqueous medium. Furthermore, the invention relates to the suspended double-flat SU-8 Janus chips and to a suspended array comprises at least two different suspended double-flat SU-8 Janus chips. Lastly, the invention relates to barcoding chips and to sensing devices comprising said suspended double-flat SU-8 Janus chips or said suspended array.

## Description

The invention relates to a process for the obtainment of suspended double-flat SU-8 Janus chips by means of SU-8 photolithography to create an arrangement of ordered SU-8 chips on substrate and soft lithography to create a planar printed or planar array on each chip, which comprises steps for the formation of a solidified membrane that is peeled off and dissolved in an aqueous medium. Furthermore, the invention related to the suspended double-flat SU-8 Janus chips and to a suspended array comprises at least two different suspended double-flat SU-8 Janus chips. Lastly the invention relates to barcoding chips and to sensing devices comprising said suspended double-flat SU-8 Janus chips or said suspended array.

### STATE OF ART

Advanced miniaturized (bio)molecular tools have benefited from dynamic design mechanisms based on tailoring their selected physical and chemical anisotropies. Mainly, microparticles consolidate these traits via anisotropic customization. Their design determines the functionality, yet their fabrication requires a compromise between their physical attributes, intended chemical modification, biocompatibility and throughput [Misra, A. C. & Lahann, J. Progress of Multicompartmental Particles for Medical Applications. Adv. Healthc. Mater. 7, 1-9 (2018)].

Great efforts have been dedicated to construct non-spherical microparticles to increase the physical anisotropic domain encompassing tailored size and morphology, shape-encoding, and complex 3D topography. Sequential fabrication methods such as droplet and flow lithography, microfluidics, centrifugation, electrohydrodynamics, and two-photon lithography have been developed to fabricate microparticles with selected physical traits. However, the combination of all of these physical traits or even further customized properties in a single microparticle to augment the functionality, is hindered by the limited availability of the fabrication approaches to incorporate complementary physical anisotropies.

Alternatively, research has also been focused on the chemical anisotropy. Extended anisotropy can be implemented with the addition of subdivisions during fabrication, albeit limited by the process, or with posterior functionalization which may be obstructed by the stochastic nature of suspended microparticles in a reactive solution or limited by the available orthogonal chemical reaction sites present on the surface of the microparticles. Imaginative solutions have been used to fabricate multiple subdivided microparticles or chips, offering an attractive approach on the encoding and anti-counterfeiting fields, yet their main use has been centered around biomedical and bioengineering applications. Nevertheless, the combination of further customized properties to increase the functionality in a single microparticle is limited by the available reactive pathways to incorporate orthogonal chemistries.

Although the consolidation of these technologies has demonstrated great advances in the microparticle field, the constant trade-off between physical anisotropies and between chemical anisotropies and their combination limits the extraordinary library of possible customized microparticles, aggravated further with miniaturization. Therefore, it is needed to develop new processes for the obtainment of non-spherical microparticles with tailored size and morphology and customized properties/functionality.

### DESCRIPTION OF THE INVENTION

The problem to be solved by process of the invention is to provide a versatile process for the obtainment of suspended double-flat SU-8 Janus chips wherein molecules biomolecules, nanoparticles or the combination thereof, are grafted onto the first and the second flat surface of each SU-8 chip by means of a specific silane crosslinker. Said process allows the controlled miniaturization on physical dimensions (1-µm lateral, 0.5-µm vertical) and molecular patterns below 1 µm². Following the process of the present invention miniaturized sensing device with a customized shape and size, coupled with sensing capabilities at the microscale is attainable. Therefore, said process is of interest for the manufacturing of
- Sensing devices, for instance, pH change detection
- Sensing devices, for instance. DNA coded recognition- selective recognition of DNA
- Creation of barcoding libraries

A first aspect of the present invention relates to a process for the obtainment of suspended double-flat SU-8 Janus chips (herein the process of the invention) comprising:
- a plurality of double-flat SU-8 chips, wherein each SU-8 chip has a first flat surface and a second flat surface,
- and molecules, biomolecules, nanoparticles or a combination thereof,
wherein said molecules, biomolecules, nanoparticles or the combination thereof are grafted onto the first and the second flat surface of each SU-8 chip, and wherein
- the molecules are preferably selected from the list consisting of modified chromophores comprising N-Hydroxysuccinimidyl ester or Succinimidyl ester groups and modified fluorophores comprising N-Hydroxysuccinimidyl ester or Succinimidyl ester groups,
- the biomolecules are preferably selected from the list consisting of carbohydrates, proteins, antibodies, enzymes and nucleic acids, and
- the nanoparticles are preferably selected from carbon-based nanoparticles comprising an amine functional group, metal nanoparticles comprising an amine functional group, ceramic nanoparticles comprising an amine functional group, polymeric nanoparticles comprising an amine functional group and semiconductor nanoparticles comprising an amine functional group;
said process characterised in that it comprises the following steps:
a) defining the shape and the size of SU-8 chips by means of SU-8 photolithography; thereby forming an arrangement of ordered SU-8 chips onto a substrate, wherein each SU-8 chip has a first flat surface and a second flat surface and wherein the second flat surface is in direct contact with the substrate;
b) functionalizing, by means of soft lithography, the first flat surface of each SU-8 chip obtained in step (a) using a silane crosslinker; thereby forming a first reactive flat surface in each SU-8 chip;
c) grafting molecules, biomolecules, nanoparticles or a combination thereof onto the first reactive flat surface of each SU-8 chip obtained in step (b) by means of soft lithography;
d) casting a mounting medium on top of the SU-8 chips obtained in step (c) and leaving to solidifying, thereby embedding the SU-8 chips obtained in step (c) into the mounting medium and forming a solidified membrane onto the substrate;
e) peeling off the solidified membrane obtained in step (d) (with the SU-8 chips obtained in step (c) embedded) from the substrate, thereby unlocking the second flat surface of each SU-8 chip;
f) functionalizing, by means of soft lithography, the unlocked second flat surface of each SU-8 chip obtained in step (e) using a silane crosslinker; thereby forming a second reactive surface in each SU-8 chip;
g) grafting molecules, biomolecules, nanoparticles or a combination thereof onto the second reactive surface of each SU-8 chip obtained in step (f) by means of soft lithography;
h) dissolving the solidified membrane of the SU-8 chips obtained in step (g) in an aqueous medium; and
(i) recollecting the suspended double-flat SU-8 Janus chips obtained in step (h) via centrifugation.

Step (a) of the process of the invention refers to defining the shape and the size of SU-8 chips by means of SU-8 photolithography; thereby forming an arrangement of ordered SU-8 chips onto a substrate, wherein each SU-8 chip has a first flat surface and a second flat surface, wherein the second flat surface is in direct contact with the substrate and wherein the substrate is locking the second flat surface of each SU-8 chip.

The term "Double-flat SU-8 chip" refers herein to an SU-8 chip which has a first flat surface (top) and a second flat surface (bottom).

The term "SU-8 photolithography" refers to an UV exposure lithography technique to pattern a SU-8 spin-coated layer in order to create an arrangement of ordered SU-8 chips on a substrate.

The term "arrangement of ordered SU-8 chips" refers to an ordered disposition or ordered joint of SU-8 chips on a substrate.

SU-8 photolithography allows the fabrication of SU-8 chips with customizable shapes and sizes in a field dominated by spherical polymer microparticles, where the only parameter that can be customized is the radius of the spheres. In the present invention, designs with features as small as 1 µm may be transferred.

In a preferred embodiment of the process of the present invention, step (a) can be repeated thereby obtaining a double-height arrangement of ordered SU-8 chips on the substrate.

The term "double-height arrangement of ordered SU-8 chips" refers herein to SU-8 chips which comprise at least two overlapping SU-8 layers of different shape and size (physical traits).

Step (b) of the process of the invention refers to functionalizing, by means of soft lithography, the first flat surface of each SU-8 chip obtained in step (a) using a silane crosslinker; thereby forming a first reactive flat surface in each SU-8 chip, wherein the silane crosslinker comprises two functional groups:
- a silane functional group and
- a functional group selected from the list consisting of primary or secondary amines, epoxide, thiol, carboxyl, azide, vinyl, isocyanate or methacryloxy groups.

The term "soft lithography" refers to techniques to print molecules, biomolecules, nanoparticles, etc by means of the contact of an elastomeric stamp covered by said molecules, biomolecules, nanoparticles, etc with a surface. In the present invention soft lithography techniques are used to print molecules, biomolecules, nanoparticles or the combination thereof onto the first and the second flat surfaces of double-flat SU8-chips. In the present invention soft lithography techniques such as microcontact printing or polymer pen lithography are preferred.

The term "silane crosslinker" refers herein to a heterobifunctional molecule with two functional groups:
- a silane functional group which reacts spontaneously to form covalent bonds with the surface of the SU-8 chips and
- a functional group selected from the list consisting of primary or secondary amines, epoxide, thiol, carboxyl, azide, vinyl, isocyanate or methacryloxy groups which form a covalent bond with the molecules, biomolecules or the nanoparticles.

Step (c) of the process of the invention refers to grafting molecules, biomolecules, nanoparticles or a combination thereof onto the first reactive flat surface of each SU-8 chip obtained in step (b) by means of soft lithography.

The term "molecules" refers herein to modified chromophores or fluorophores comprising N-Hydroxysuccinimidyl ester or Succinimidyl ester groups which can be grafted onto a reactive surface by means of a silane crosslinker. While the silane functional group reacts spontaneously to form covalent bonds with the surface of the SU-8 chips, the functional group selected from the list consisting of primary or secondary amines, epoxide, thiol, carboxyl, azide, vinyl, isocyanate or methacryloxy groups form a covalent bond with the N-Hydroxysuccinimidyl ester or Succinimidyl ester groups present in the modified chromophores or fluorophores. Thereby molecules are covalently bonded onto the first reactive flat surface of each SU-8 chip. Grafting fluorophores is of interest in chemical sensing, as for instance changing the emission intensity versus pH, or for barcoding by using the fluorophores as bits, or for imaging as tracking the particles.

The term "biomolecules" refers herein to carbohydrates such as sugars and starches, proteins and antibodies, enzymes, and nucleic acids such as DNA and RNA. Said biomolecules can be grafted onto a reactive surface comprising by means of the silane crosslinker: While the silane functional group reacts spontaneously to form covalent bonds with the surface of the SU-8 chips, the functional group selected from the list consisting of primary or secondary amines, epoxide, thiol, carboxyl, azide, vinyl, isocyanate or methacryloxy groups form a covalent bond with the amines present in the biomolecules or the amine-modified biomolecules, for instance amine-modified oligos. Thereby, biomolecules are covalently bonded onto the first reactive flat surface of each SU-8 chip. Grafting of biomolecules is of interest in proteomics and genomics assays.

The term "nanoparticles" refers herein to amine-modified nanoparticles. Examples are carbon-based nanoparticles such as fullerenes and carbon nanotubes, metal nanoparticles made of metal precursors, ceramic nanoparticles made of non-metallic solids, polymeric nanoparticles, and semiconductor nanoparticles as Quantum Dots, each of them comprising an amine functional group, which can be grafted onto a reactive surface by means of the silane crosslinker. While the silane functional group reacts spontaneously to form covalent bonds with the surface of the SU-8 chips, the functional group selected from the list consisting of primary or secondary amines, epoxide, thiol, carboxyl, azide, vinyl, isocyanate or methacryloxy groups form a covalent bond with the amine present in the amine-modified nanoparticle. Thereby, nanoparticles are covalently bonded onto the first reactive flat surface of each SU-8 chip in this way. Grafting nanoparticles is of interest for imaging, barcoding, increase of surface reactivity, catalysis or nucleation sites.

An advantage of the process of the invention is that the functionalization and the grafting of the first flat surface of the SU-8 chip does not interfere with the functionalization and the grafting of the second flat surface of the SU-8 chip. Orthogonal chemistry is herein avoided.

In a preferred embodiment of the process of the invention steps (b) and (c) can be repeated.

Furthermore, the SU-8 chips obtained in step (c) can be rinsed and washed to eliminate excess of molecules, biomolecules, nanoparticles or a combination thereof without losing the integrity of each SU-8 chip.

The molecules, biomolecules or nanoparticles grafted onto the first flat surface of each SU-8 chip obtained in step (c) can form
- a first planar printed arrangement
- or a first planar array

The term "first planar printed arrangement" refers to molecules, biomolecules or nanoparticles grafted onto the first flat surface of each SU-8 chip which only comprises one type of molecules, biomolecules or nanoparticles grafted onto the first flat surface of each SU-8 chip.

The term "first planar array" refers to molecules, biomolecules or nanoparticles grafted onto the first flat surface of each SU-8 chip which comprises the combination of molecules, biomolecules or nanoparticles grafted onto the first flat surface of each SU-8 chip.

In a preferred embodiment of the process of the invention, the molecules, biomolecules or nanoparticles grafted onto the first flat surface of each SU-8 chip obtained in step (c) comprises only one type of molecules, biomolecules or nanoparticles grafted onto the first flat surface of each SU-8 chip; thereby forming a first planar printed arrangement.

In another preferred embodiment of the process of the invention, the molecules, biomolecules or nanoparticles grafted onto the first flat surface of each SU-8 chip obtained in step (c) comprises the combination of molecules, biomolecules or nanoparticles grafted onto the first flat surface of each SU-8 chip; thereby forming a first planar array.

It is an advantage for the process of the invention since the functionalization of one flat surface of the SU-8 chip by a specific silane crosslinker such an epoxysilane crosslinker could result in the grafting of the combination of for instance protein, DNA probes and Quantum Dots in a single flat surface of said SU-8 chip. The further functionalization of the other flat surface of the SU-8 chip in the same way is therefore chemically independent of the previous ones.

Soft lithography of steps (b) and (c) can covered the whole first flat surface of each SU-8 chip at once. In a preferred embodiment of the present invention, soft lithography of steps (b) and (c) is performed in the form line patterns and/or spots. Soft lithography of steps (b) and (c) allows the precise and reproducible line and/or spot pattern, which is of interest in barcoding applications and multiplexing capabilities.

The term "barcode or bar code" is a method of representing data in a visual, machine-readable form. Barcodes represented data by varying the widths and spacings of parallel lines are commonly referred to as linear or one-dimensional (1D) and can be scanned by special optical scanners, called barcode readers. Two-dimensional (2D) variants using rectangles, dots, hexagons and other geometric patterns are called matrix codes or 2D barcodes, although they do not use bars as such. 2D barcodes can be read or deconstructed using application software on mobile devices with inbuilt cameras, such as smartphones.

Step (d) of the process of the invention refers to casting a mounting medium on top of the arrangement of the grafted ordered SU-8 chips obtained in step (c) and leaving to solidifying, thereby embedding the arrangement of grafted ordered SU-8 chips obtained in step (c) into the mounting medium and forming a solidified membrane onto the substrate.

The term "mounting medium" refers herein to a non-reactive polymeric solution in liquid phase that solidifies at room temperature and posteriorly can be dissolved in aqueous-media without damaging the chemically functionalized chips. An example of mounting media is Fluoromount(TM). Another example is a solution of 10% polyvinyl alcohol, 5% glycerol in 25 mM Tris buffer pH 8.7.

Step (e) of the process of the invention refers to peeling off the solidified membrane obtained in step (d) from the substrate, thereby unlocking the second flat surface of each SU-8 chip.

Step (f) and step (g) of the present invention refers to the functionalization and the grafting of the unlocked second flat surface of each SU-8 chip obtained in step (e) in the same way as it was performed for the first flat surface of each SU-8 chip. Silane crosslinker and preferred molecules, biomolecules and nanoparticles are the same as previously mentioned for step (b).

Step (f) and step (g) are independent from the chemist of the top-flat surface of the chips (the first flat surface of each SU-8 chip) and the chemical functionalization of the bottom flat surface (second flat surface of each SU-8 chip) do not damage the previous functionalization of the top flat surface.

Particularly, step (f) of the process of the present invention refers to functionalizing, by means of soft lithography, the unlocked second flat surface of each SU-8 chip obtained in step (e) using a silane crosslinker; thereby forming a second reactive surface in each SU-8 chip and step (g) refers to the grafting molecules, biomolecules, nanoparticles or a combination thereof onto the second reactive surface of each SU-8 chip obtained in step (f) by means of soft lithography. As mentioned before, molecules, biomolecules, nanoparticles or the combination thereof, are covalently bonded onto the second reactive flat surface of each SU-8 chip in this way.

In a preferred embodiment of the present invention steps (f) and (g) can be repeated.

The molecules, biomolecules or nanoparticles grafted onto the second flat surface of each SU-8 chip obtained in step (g) can form
- a second planar printed arrangement
- or a second planar array

The term "second planar printed arrangement" refers to molecules, biomolecules or nanoparticles grafted onto the second flat surface of each SU-8 chip which only comprises one type of molecules, biomolecules or nanoparticles grafted onto the second flat surface of each SU-8 chip.

The term "second planar array" refers to molecules, biomolecules or nanoparticles grafted onto the second flat surface of each SU-8 chip which comprises the combination of molecules, biomolecules or nanoparticles grafted onto the second flat surface of each SU-8 chip.

In a preferred embodiment of the process of the invention, molecules, biomolecules or nanoparticles grafted onto the second flat surface of each SU-8 chip obtained in step (g) comprises only one type of molecules, biomolecules or nanoparticles grafted onto the second flat surface of each SU-8 chip; thereby forming a second planar printed arrangement.

In another preferred embodiment of the process of the invention, molecules, biomolecules or nanoparticles grafted onto the second flat surface of each SU-8 chip obtained in step (g) comprises the combination of molecules, biomolecules or nanoparticles grafted onto the second flat surface of each SU-8 chip; thereby forming a second planar array.

In another preferred embodiment of the process of the invention, soft lithography of steps (f) and (g) is performed in the form line patterns and/or spots. As mentioned before, soft lithography steps allow the precise and reproducible line and/or sport pattern, which is of interest in barcoding applications.

Step (h) of the present invention refers to dissolving the solidified membrane of the SU-8 chips obtained in step (g) in an aqueous medium; thereby obtaining suspended double-flat SU-8 Janus chips.

The term "aqueous medium" refers herein to any solution based in water. Examples are DI water, physiological medium or cell culture medium.

The term "Double-flat SU-8 Janus chip" refers herein to a double-flat SU-8 chip having a first flat surface (top) and a second flat surface (bottom), wherein molecules, biomolecules, nanoparticles or the combination thereof are grafted onto the first and the second flat surface of each SU-8 chip.

The term "Suspended double-flat Janus chips" refers herein to a suspension of Double-flat SU-8 Janus chip in an aqueous media. As mentioned before, the term "aqueous medium" refers herein to any solution based in water. Examples are DI water, physiological medium or cell culture medium.

In step (d) of the process of the present invention a solidified membrane located onto the substrate is obtained; said solidified membrane is peeled off from the substrate in step (e) and dissolved in an aqueous medium in step (h). In this way, the risk of chemical damage is prevented during grafting of the second flat surface of each SU-8 chip.

Furthermore, the suspended double-flat SU-8 Janus chips obtained in step (h) are recollected via centrifugation in step (i). This liberation steps protects the physical integrity of the SU-8 chips and prevents the creation of debris.

A second aspect of the present invention relates to suspended double-flat Janus chips (herein the chips of the invention), preferably obtained by the process of the invention mentioned above, and characterized in that they comprise:
- a plurality of double-flat SU-8 chips, wherein each SU-8 chip has a first flat surface and a second flat surface,
- and molecules, biomolecules, nanoparticles or a combination thereof,
wherein said molecules, biomolecules, nanoparticles or the combination thereof are grafted onto the first and the second flat surface of each SU-8 chip.

In a preferred embodiment of the chips of the invention, the molecules are selected from the list consisting of modified chromophores comprising N-Hydroxysuccinimidyl ester or Succinimidyl ester groups and modified fluorophores comprising N-Hydroxysuccinimidyl ester or Succinimidyl ester groups.

In another preferred embodiment of the chips of the invention, the biomolecules are selected from the list consisting of carbohydrates, proteins, antibodies, enzymes and nucleic acids.

In another preferred embodiment of the chips of the invention, the nanoparticles are selected from carbon-based nanoparticles comprising an amine functional group, metal nanoparticles comprising an amine functional group, ceramic nanoparticles comprising an amine functional group, polymeric nanoparticles comprising an amine functional group and semiconductor nanoparticles comprising an amine functional group.

A third aspect of the present invention relates to a suspended array (herein the suspended array of the invention) characterized in that it comprises a mixture of at least two different suspended double-flat Janus chips, wherein each suspended double-flat Janus chips (chips of the invention) comprises (as defined before):
- a plurality of double-flat SU-8 chips, wherein each SU-8 chip has a first flat surface and a second flat surface,
- and molecules, biomolecules, nanoparticles or a combination thereof,
wherein said molecules, biomolecules, nanoparticles or the combination thereof are grafted onto the first and the second flat surface of each SU-8 chip.

A fourth aspect of the present invention relates to the process for the obtainment of the suspended array of the invention characterized in that it comprises a step of mixing at least two different suspended double-flat Janus chips, for instance, by means of recollection of the populations of suspended chips from their initial container and adding them to the same container.

A fifth aspect of the present invention a barcoding chip characterized in that it comprises the suspended double-flat Janus chips (chips of the invention) or the suspended array mentioned above (array of the invention).

In a preferred embodiment of the barcoding chip, said barcoding chip is a color-barcoding chip wherein at least a nanoparticle is grafted on the first or the second flat surface of each SU-8 chip in the form of line patterns and/or spots and said nanoparticle is a Quantum Dot.

The term "color-barcoding chips" refers herein to chips with lines or spots of a unique or of several colors that define a code.

The main advantage of using amine-modified Quantum Dots is their long emission stability and reduce photobleaching.

A sixth aspect of the present invention refers to a sensing device characterized in that it comprises the suspended double-flat Janus chips (chips of the invention) or the suspended array mentioned above (suspended array of the invention).

In a preferred embodiment of the sensing device, said sensing device is a pH sensing device wherein at least a molecule is grafted on the first or the second flat surface of each SU-8 chip, said molecule is a pH sensing fluorophore comprising N-Hydroxysuccinimidyl ester or Succinimidyl ester groups.

The term "pH sensing fluorophore" refers herein to any responsive fluorophore molecule where its fluorescence emission intensity is dictated by the immediate ambient pH.

In a preferred embodiment of the sensing device, said sensing device is a DNA sensing device wherein at least a DNA probe is grafted on the first or the second flat surface of each SU-8 chip said biomolecule is a DNA probe.

The term "DNA probe" refers herein to short single-stranded DNA stretches used to detect the presence of complementary nucleic acid sequences by hybridization.

Unless otherwise defined, all technical and scientific terms used herein have the same meaning as commonly understood by one of ordinary skilled in the art to which this invention belongs. Methods and materials similar or equivalent to those described herein can be used in the practice of the present invention. Throughout the description and claims the word "comprise" and its variations are not intended to exclude other technical features, additives, components, or steps. Additional objects, advantages and features of the invention will become apparent to those skilled in the art upon examination of the description or may be learned by practice of the invention. The following examples and drawings are provided by way of illustration and are not intended to be limiting of the present invention.

### BRIEF DESCRIPTION OF THE DRAWINGS

FIG. 1 Scheme of the preparation of suspended double-flat SU-8 Janus chip with grafted fluorophore, DNA probe, protein and Quantum Dots.
FIG. 2. Scanning electron microscopy images of SU-8 chips on the substrate identified by their customized physical anisotropy: (a) fiducial marker, (b) aspect ratio width length 1:2, 1:3, and 1:4, (c) branching, and (d) faceting.
FIG. 3. Scheme of the lateral view of suspended of double-height double-flat SU-8 chips with grafted fluorophore, DNA probe, protein and Quantum Dots.
FIG. 4. Scanning electron microscopy of double-height SU-8 chip consisting of an initial fiducial chip and a secondary branching chip.
FIG. 5. Optical microscopy image of liberated chips resuspended in water.
FIG. 6. Fluorescence microscopy images of an arrangement of fiducial SU-8 chips grafted with the red-emitting fluorophores to define a) spots or b) lines on top flat surface of the chips and backfilled with a green-emitting fluorophore for visualization purposes. c) The whole top flat surface of the arrangement of chips patterned to graft a red-emitting fluorophore. d) The top flat surface and the lateral sides of the arrangement of chips grafted with red-emitting fluorophore.
FIG. 7. a) Fluorescence microscopy images of an arrangement of branching SU-8 chips on the substrate and grafted with red-emitting fluorophore. b) The arrangement of grafted chips is liberated and resuspended in water.
FIG. 8. a) Fluorescence microscopy images of liberated branched SU-8 chips with an initial epoxy reactive surface and grafted with a Texas-red-labelled oligo. b) Fluorescence microscopy images of a liberated Aspect Ratio SU-8 chips with an initial epoxy reactive surface and grafted with GFP.
FIG. 9. a) Fluorescence microscopy image of an arrangement of aspect ratio SU-8 chips grafted with QD545. b) Fluorescence microscopy image of a population of liberated aspect ratio SU-8 chips grafted with QD545. c) Fluorescence microscopy image of an arrangement of fiducial SU-8 chips grafted with QD525. d) Fluorescence microscopy image of a population of liberated fiducial SU-8 chips grafted with QD525.
FIG. 10. a) Red fluorescent microscopy channel image of liberated Fiducial chips grafted with red-emitting fluorophore on the top flat surface and green-emitting fluorophore on the bottom flat surface. b) The same suspended chips observed with the green fluorescent channel. c) Composite image of the previous images. d) Red fluorescent microscopy channel image of liberated Faceting chips grafted with red-emitting QD655 on the top flat surface and green-emitting fluorophore on the bottom flat surface.
FIG. 11. a) Optical microscopy image of liberated and suspended double-height SU-8 chips. b) Fluorescence microscopy image of the same double-height SU-8 chips grafted with QD655 on the branching side and QD545 on the Fiducial side.
FIG. 12. Fluorescence microscopy images of suspended Branched SU-8 chips grafted with pH sensitive red fluorophore at different pH: a) pH 4, b) pH 7, and c) pH 9.
FIG. 13. a) Red fluorescent microscopy channel image of liberated Fiducial chips grafted with QD655 on the top flat surface and green-emitting oligo hybridized to the probe grafted onto the bottom flat surface. b) The same suspended chips observed with the green fluorescent channel. c) Composite image of the previous images.
FIG. 14. Composite image of the red and green fluorescent channels of suspended Aspect Ratio SU-8 chips with distinct red- and green-emitting fluorophore spots on the top surface and QD545 grafted onto the bottom surface.

### EXAMPLES

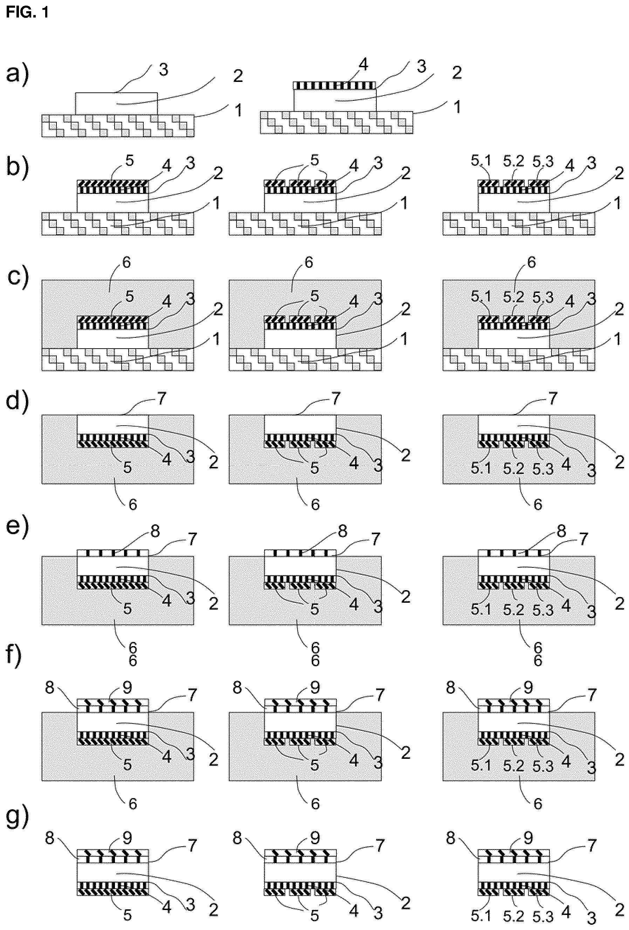

FIG. 1 shows a general scheme of the preparation of a suspended double-flat Janus chip with grafted fluorophore, DNA probe and protein molecules, and nanoparticles as Quantum Dots.
a) The SU-8 chip (2) is part of an arrangement of ordered chips fabricated directly over a substrate (1) by means of SU-8 lithography. The top flat surface of the chip (3) is functionalized to obtain the reactive surface with selected cross-linkers (4) via microcontact printing.
b) The arrangement of ordered chips with the reactive surface with selected cross-linkers is patterned with soft lithography as microcontact printing for a complete coverage of the chip or with Polymer Pen lithography to graft a planar array of the same molecules or nanoparticles (5). Alternatively, different molecules and nanoparticles can be patterned independently with successive Polymer pen lithography processes to graft planar array with selected molecules or nanoparticles in discreet regions of the chip (5.1, 5.2, 5.3).
c) Mounting medium (6) is cast over the arrangement of ordered SU-8 chips with the reactive surface with selected cross-linkers with either the complete coverage of the same molecules and nanoparticles, or the planar array of the same molecules and nanoparticles, or the planar array of different molecules and nanoparticles, and left to solidify, embedding the chips in its matrix.
d) The solidified mounting medium is peeled from the substrate hauling the chips along its matrix, exposing the bottom flat surface of the chips (7). The substrate (1) can be discarded.
e) The exposed bottom flat surface (7) of the chips is subsequently patterned with soft lithography as microcontact printing to obtain a reactive surface with selected cross-linkers (8).
f) The reactive surface with selected cross-linkers (8) from the bottom flat surface (7) of the SU-8 chips can be patterned with soft lithography as microcontact printing to graft molecules or nanoparticles (9).
g) The solidified mounting medium (6) is dissolved in an aqueous medium to obtain the double-flat chips as Janus chips.

We fabricated polymeric chips of various sizes (3-12 µm), thickness (0.5-1.2 µm), and topographies, coupled with faceting, fiducial, aspect ratio, and branching dimensions. Then, we selectively functionalized the top and bottom flat surfaces of the chips to generate 0D, 1D, 2D, and 3D patterns of molecules as fluorescent probes, biomolecules (proteins and DNA strands), and nanoparticles as quantum dots (QDs) with high spectral resolution. Importantly, the functionalization allows the use of multi-chemistry strategies to pattern probes with different or interfering immobilization chemistries without the need to consider orthogonal chemistry. Finally, we demonstrate the sensing and detecting capabilities of the suspended double-flat Janus chips to detect pH changes in the environment and the selective recognition of DNA.

### Materials and methods:

All printing stamps, for microcontact printing or polymer pen lithography, were fabricated using Sylgard 184 PDMS elastomer (Dow Corning), and all chips with the SU-8 2000.5 resin (MicroChem). The HIPR 6512 positive photoresist (Fujifilm Electronic Materials, USA) and the Sioetch^{®} remover (Selectipur) were used during microfabrication. The 3-glycidoxypropyltrimethoxysilane (epoxy-silane) and the (3-Aminopropyl)triethoxysilane (APTES) silanes (Sigma-Aldrich) were used independently as crosslinkers between the SU-8 and the subsequent surface modification. 1H,1H,2H,2H-Perfluorooctyltrichlorosilane (PFOTCS) was acquired from Fluka Other reagents include ethylenediamine (EDA), anhydrous dimethylsulfoxide (DMSO), acetonitrile, disodium hydrogen phosphate (Na₂HPO₄), Fluoromount^{™} aqueous mounting media, Hybridization solution, saline-sodium citrate (SSC) buffer 20x (Sigma-Aldrich), and ethanol (Panreac). All of the fluorescent probes were either Qdot^{™} ITK^{™} Amino (PEG) Quantum Dots (QDs), DyLight NHS Ester fluorophores or pHrodo^{™} Red, succinimidyl ester (ThermoFisher Scientific). The modified oligonucleotide strands had an anchoring moiety and/or fluorescent probe (biomers.net).

### • Fabrication of PPL stamp mold:

A 525 µm-thick P-type <100> silicon wafer was wet-oxidized at 1100 ºC to obtain a 1 µm-thick SiO2 layer. Then, a 1.2 µm-thick layer of the HIPR 6512 photoresist was spun over the oxidized wafer and exposed to UV light through a photomask using a MA56 mask aligner (Karl Süss, Germany). After developing and hard-baking the resist at 200 ºC for 30 min, the SiO₂ layer was dry-etched using a C2F6/CHF3 mixture in a Drytek Quad 484 RIE (Drytek, USA). Later 40% KOH anisotropic etching at 75 ºC for 4 min attacked the exposed Si to create the inverted pyramids. The remaining SiO₂ was removed with Sioetch^{®}. Lastly the mold was plasma activated for 30 s at 100 W and exposed to a saturated PFOTCS atmosphere for 1 h. After baking at 75 °C for 1 h, the mold was rinsed with ethanol and dried under a N₂ flow.

### • Fabrication of PDMS stamps:

A 10:1 w/w prepolymer-catalyst mixture was thoroughly stirred, degassed and poured over either a pristine silicon wafer for flat stamps, or onto the selected silicon molds with the desired features. To prevent the contraction of the PDMS stamps, a plasma-activated glass slide was placed over the uncured PDMS and left to cross-link at 75 °C for 1 h to a final thickness of ≈100 µm.

### • Fabrication of SU-8 chips:

Standard SU-8 photolithography was used to define the shape and size of the SU-8 chips. A pristine 4-in silicon wafer was spin-coated with SU-8 2000.5 to obtain a homogenous 500-nm-thick layer, which was subsequently baked and exposed to UV-light trough a photomask with a dose of 445 mJ cm-2. A final baking step was done before developing the uncrosslinked resin. The wafer was divided into 1 × 1 cm2 portions.

### • Reactive surfaces with selected cross-linkers:

A flat PDMS stamp was incubated in either a 2% v/v epoxy-silane or a 2% v/v APTES ethanolic solution for 15 min, and subsequently dried with N₂. The arrangement of SU-8 chips on the substrate were activated under oxygen plasma at 500 W during 30 s and were immediately contact-printed with the incubated stamp during 10 s. The arrangement of SU-8 chips with the reactive surface were subsequently cured at 100 ºC during 20 min in a nitrogen atmosphere and brought to room temperature rapidly to induce thermal shock at the SU-8-substrate boundary, to aid with the subsequent liberation of the chips. The same protocol was followed to functionalize the bottom surface of the chips, which is performed after completing the modification of the first (top) surface of the SU-8 chip and the peel-off of the solidified mounting medium.

### • µContact printing and PPL of fluorophores:

The amine-reactive NHS ester fluorophores were initially diluted in DMSO and subsequently in a 4:3 v/v acetonitrile:30 mM Na₂HPO₄ solution to a final concentration of 100 µg mL-1. The PDMS stamp was plasma-activated and subsequently incubated with the solution. After 2 min incubating, the stamp was blown dry with N₂ and was brought into contact with the APTES-modified arrangement of SU-8 chips during 10 s. After lift-off, the ink was left to react during 1 h in a humid and dark chamber and rinsed thoroughly with Deionized (DI) water for 30 s.

### • µContact printing of QDs:

QDs with different emission were diluted in a 30 mM Na₂HPO₄ aqueous solution to a final 0.8 µM concentration. The inked stamp contacted the epoxy-modified SU-8 arrangement of SU-8 chips during 10 s to transfer the QDs to their activated surface. The arrangement of SU-8 chips was left to react for 1 h. Afterwards, the unreacted epoxy moieties were blocked with a 2% v/v EDA solution in 30 mM Na₂HPO₄ buffer during 1 h and finally rinsed thoroughly with DI water for 30 s.

### • µContact printing of DNA strands:

The following modified oligonucleotide strands were suspended in DDI water to an initial concentration of 100 µM and subsequently in the Na₂HPO₄ solution to a final concentration of 10 µM:
TS314: 5'-[Aminolink C6]-CTT GGA GCG AAC GAC CTA C-3' (SEQ ID NO: 1) RP-TS314: 5'-[DY-485-XL]-GTA GGT CGT TCG CTC CAA G-3' (SEQ ID NO: 2) TS315: 5'-[Aminolink C6]-CAA CAC TCA ACC CTA TCT CG-[TxRd] (SEQ ID NO: 3) RP-TS315: 5'-[DY-490]-CGA GAT AGG GTT GAG TGT TG-3' (SEQ ID NO: 4)

Subsequently, a PDMS stamp was incubated with the oligo solution for 15 min, rinsed with Distilled De-lonized (DDI) water and printed onto the epoxy-modified arrangement of SU-8 chips for 10 s. The arrangement of SU-8 chips was left to react in dark and humid atmosphere for 1 h before blocking with a 2% v/v EDA solution in 30 mM Na₂HPO₄ buffer during 1 h. To hybridize, the complementary strand was suspended to a final concentration of 10 µM in the hybridization buffer and left to react at 36 ºC during 2 h. Afterwards, the chips were rinsed in SSC 2x for 5 min, then rinsed in SSC 1x for 5 min, followed by rinsing during 5 min in SSC 0.1x and finally rinsed in DDI water. Between each rinsing step, the chips were concentrated by centrifugation and the supernatant was recollected and eliminated.

### • Liberation of printed chips:

A drop of the aqueous mounting media was placed on top of the arrangement of SU-8 chips on the substrate and left to solidify at room temperature. A manual lateral force was later used to separate the solidified medium from the substrate. The solidified mounting media with the embedded chips was dissolved in DI water and the suspended chips were collected by centrifugation.

### EXAMPLE 1 Characterization of SU-8 chips after step (a) of defining the shape and the size of the SU-8 chips

We began by establishing the required physical properties to obtain the desired SU-8 chip. The physical definition dictates the size and shape of each SU-8 chip, together with morphological dimensions such as topography. Next, we defined the physical descriptor on a photomask. Standard photolithography was later used to transcribe the design onto SU-8 with a defined thickness (0.5-1.2 µm). The arrangement of ordered SU-8 chips on the substrate was obtained after the development of the SU-8. In FIG. 1a, a single chip (2) from the arrangement of ordered SU-8 chips is represented over the substrate (1), with its exposed top flat surface (3).

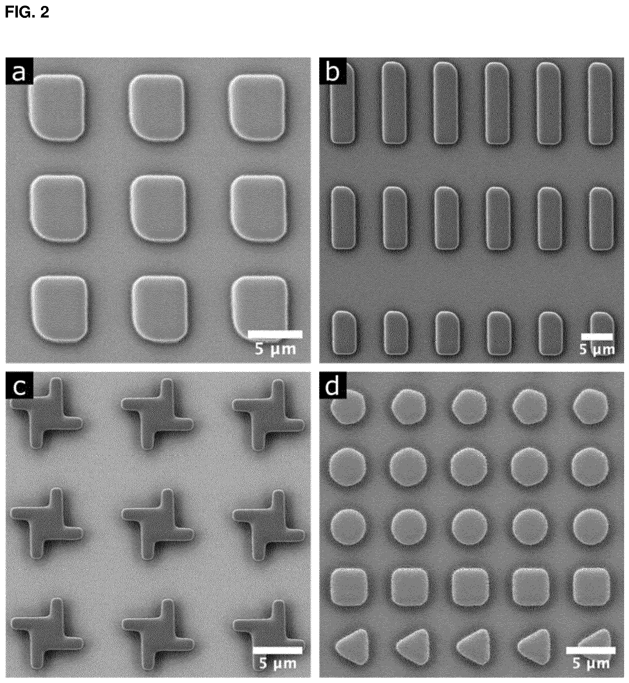

FIG. 2 shows the shape and size of arrangements of SU-8 chips over the substrate using scanning electron microscopy. Each arrangement of SU-8 chips contains a specific physical trait: a) fiducial mark, b) aspect ratio, c) branching, and d) faceting.

This approach allows the fabrication of SU-8 chips with customizable shapes and sizes in a field dominated by spherical polymer microparticles, where the only parameter that can be customized is the radius of the spheres. The photolithographic step allows transferring designs with features as small as 1 µm.

### EXAMPLE 2 Characterization of double-height SU-8 chips: after step (a) of defining the shape and the size of the SU-8 chips

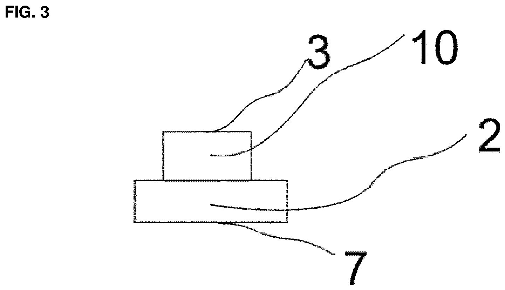

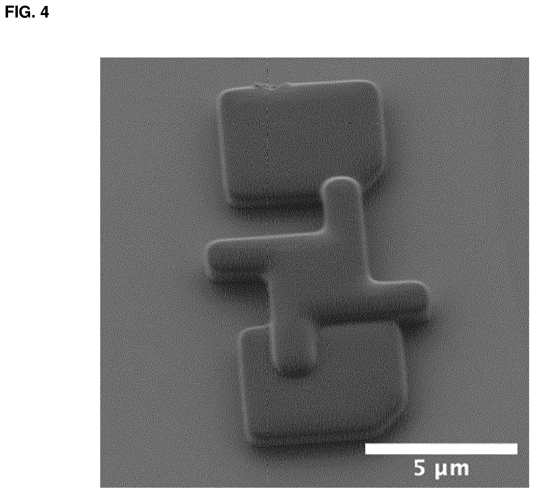

Double-height SU-8 chips are fabricated following two consecutive photolithography steps, a first to define an initial SU-8 chip directly over the substrate and a second photolithography step to create the second chip over the initial one, as represented in FIG. 3. A resulting double height chip can be seen in FIG. 4.

Initially, an arrangement of ordered SU-8 chips is fabricated via SU-8 photolithography and left over the substrate. A second SU-8 photolithography process is performed over the initial arrangement of ordered SU-8 chips obtaining SU-8 chips with features at a secondary height (10). Molecules and nanoparticles are grafted onto the top flat surface (3) of the double height SU-8 chips as described in Fig. 1a-b. The double height SU-8 chips are liberated with casting medium (6) as described in Fig. 1c-d. Molecules and nanoparticles are grafted onto the bottom flat surface (7) of the double height SU-8 chips.

This fabrication method ensures the obtention of SU-8 chips with two opposing top and bottom flat surfaces for subsequent chemical functionalization. Also, the double-height chips can incorporate physical traits of two distinct chips in a single device.

### EXAMPLE 3 Characterization of liberated SU-8 chips.

The liberation step is crucial to obtain the suspended grafted SU-8 chips yet it must provide protection to the surface functionalization. Some liberation methods required the elimination of a sacrificial layer between substrate and chips using harsh chemical methods, damaging the sensitive surface functionalization. Conversely, immersed ultrasound helped release the chips from the fabrication substrate, yet this method may shatter the chips and also may interfere with the stability and functionality of the surface modification. Alternatively, shear force has also been used to scrape the SU-8 chips from the substrate, yet, this may unevenly break the chips and generate debris.

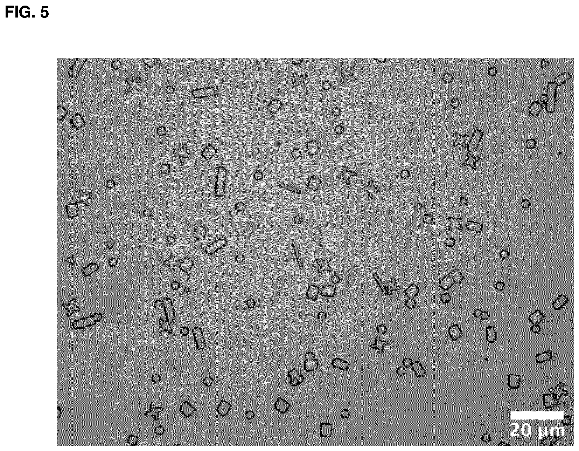

Therefore, to liberate the grafted SU-8 chips obtained following the process of the present invention following the steps in Example 1, mounting medium cast on top of the grafted chips, (6) in FIG. 1c, and is then left to solidify at room temperature (t = 21 ºC, RH 50%), embedding the grafted SU-8 chips into the solidified matrix. The resulting solidified membrane is later peeled from the substrate hauling the grafted SU-8 chips along. This membrane with the SU-8 chips can be dissolved in an aqueous medium to free the arrangement of chips and obtain suspended chips, preventing the risk of chemical damage. A collection of the suspended SU-8 chips can be observed in the optical microscopy image in FIG. 5.

The chips can be recollected via centrifugation for further characterization or usage. This liberation method protects the physical integrity of the SU-8 chips and prevents the creation of debris.

### EXAMPLE 4 Characterization of grafted SU-8 chips with fluorophores creating defined patterns on the top flat surfaces of the chips.

Heterobifunctional crosslinkers were then used to generate the reactive surface on the top surface of each SU-8 chip fixed on the substrate number (4) in FIG. 1a. We developed soft lithography and wet chemistry protocols to pattern the reactive surface of the SU-8 chips with selected inks. Microcontact printing (µCP) was used to pattern the whole chip or to create line patterns on top of the fixed chips with the same molecule or nanoparticle, as represented in (5) in FIG. 1b. Polymer pen lithography (PPL) grafted micrometric resolvable features (spots) in selected positions, coupled with multiple molecules or nanoparticles with different light emission, obtaining the grafted features (5.1, 5.2, and 5.3) represented in FIG. 1b. Having multiple spots identifiable by their position over each SU-8 chip inks provides the base to create multiplexed chips having the spots emit at the same color, eliminating the restrictions of color-based multiplexed chips limited by the number of spectrally-resolved dyes.

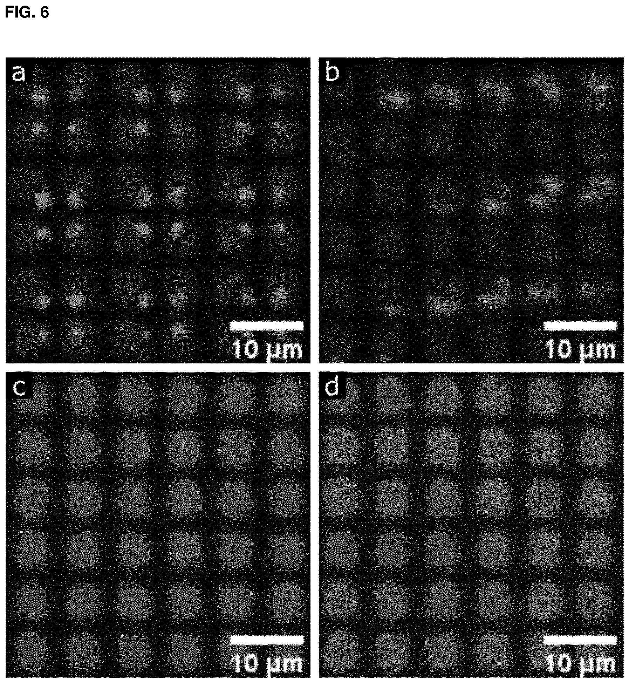

An amine-bearing silane (APTES, see Materials and Methods) is fixed onto the top flat surface of an arrangement of SU-8 chips fabricated in Example 1 to create a reactive surface with the selected cross-linker. Two NHS-ester-derivatized fluorophores with red and green emissions were grafted onto the reactive surface via soft lithography or wet chemistry. In FIG. 6a, the red-emitting fluorophore was grafted using polymer pen lithography to create spots over the arrangement of immobilized chips. Alternatively, fluorophore lines can be grafted onto the top surfaces of the arrangement of chips with microcontact printing, as demonstrated in FIG. 6b. To better visualize with fluorescence microscopy, the arrangement of chips and the grafted spots and lines, a green-emitting fluorophore was backfilled to cover the rest of the top surfaces of the arrangement of chips. Microcontact printing is used to graft a fluorophore over the entire top flat surface of the arrangement of chips, which can be observed in FIG. 6c. Alternatively, an arrangement of chips can be submerged in a solution of the fluorophore to graft the fluorophores via wet chemistry to the lateral sides and top flat surface of the chips, as shown in FIG. 6d.

This grafting method creates customized patterns on the top surface of the arrangement of chips. Additionally, the arrangement of chips can be rinsed and washed after each patterning process to eliminate excess molecule or nanoparticle without losing SU-8 chips.

### EXAMPLE 5 Characterization of grafted SU-8 chips with fluorophores and their subsequent liberation

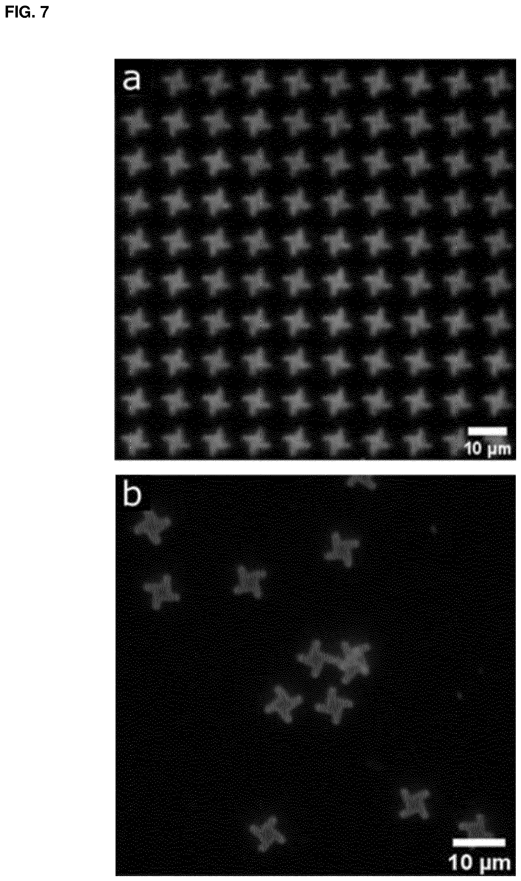

Fluorescent chips have been used to create tagging, identification and barcoding devices in applications at the microscale. The top flat surface of the present invention can be grafted with selected fluorophores to achieve similar purposes. To accomplish this, the top flat surface of an arrangement of branching SU-8 chips is first modified to create a reactive surface with a selected amine-bearing cross-linker. Secondly, the top flat surface is grafted with a red-emitting NHS-ester-derivatized fluorophore via microcontact printing. The resulting emission of the grafted fluorophores over the arrangement of branching SU-8 chips can be seen in FIG. 7a. The grafted SU-8 chips are liberated using the mounting medium presented in Example 3 and resuspended in water. The fluorescent emission of the red-emitting fluorophore grafted on the chips is seen in FIG. 7b.

The fluorescence emission is detected through the chips as the material's optical transmittance is <95% on the selected wavelengths, observing the emission whether the grafted face is facing up or down, with negligible autofluorescence. This approach allows the customization of the top flat surface of the arrangement of SU-8 chips with selected cross-linkers with specific moieties such as amine, epoxy or thiol to create the reactive surface where the fluorophore or nanoparticle can covalently bind.

### EXAMPLE 6 Characterization of grafted SU-8 chips with nucleic acids and proteins and the subsequent liberation of the grafted SU-8 chips.

Alternatively, the covalent immobilization of nucleic acids and proteins onto the arrangement of SU-8 chips provide favourable stability and biomolecule accessibility for biosensing, biocatalysis, and point-of-care monitoring. Current functionalization methods employ wet chemistry to coat randomly the chips. To direct the functionalization towards the chosen position of surface of the chips, the top flat surface of the arrangement of SU-8 chips are initially functionalized with an epoxy-containing crosslinker creating a reactive surface, which reacts spontaneously with secondary amines present in modified oligos and in proteins.

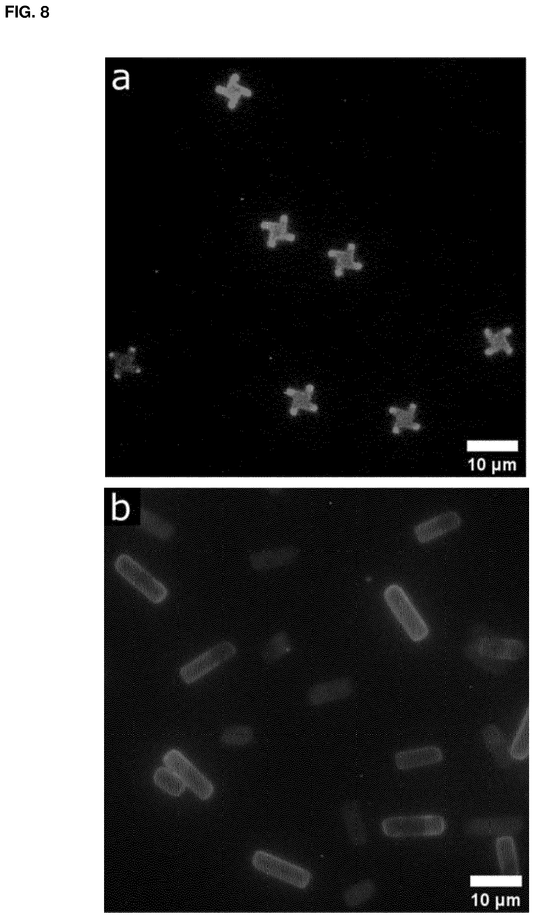

To accomplish this, an arrangement of branching SU-8 chips with a reactive epoxy-silane (Materials and Methods) top flat surface was patterned via microcontact printing to graft a Texas-red-labelled, amine-derivatized oligo. Similarly, an arrangement of Aspect Ratio SU-8 chips with a reactive epoxy-silane (Materials and Methods) top flat surface was patterned via microcontact printing with green fluorescent protein (GFP). After the oligos and proteins were grafted, the chips were liberated and recollected for characterization following the process in Example 3. The resulting liberated grafted SU-8 chips can be characterized with fluorescent microscopy as seen in FIG. 8. The fluorescence signature in FIG. 8a confirms the presence of the Texas-red-labelled oligo present on the top surface of the chips. Similarly, the green fluorescence emission in FIG. 8b confirms the grafted GFP over the top surface of the liberated chips.

The liberation method protects the integrity of the grafted biomolecules so they remain functional for further utilization of the chips.

### EXAMPLE 7 Characterization of grafted SU-8 chips with Quantum Dots and the subsequent liberation of the grafted SU-8 chips.

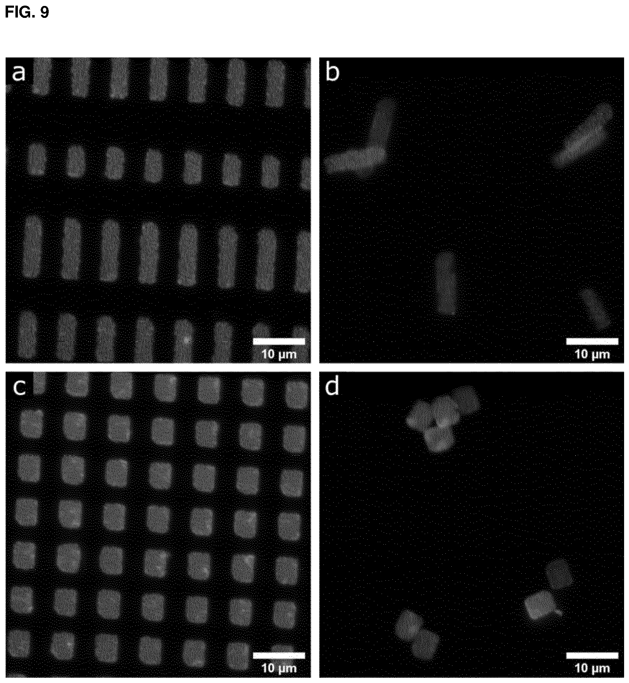

The present invention permits grafting Quantum Dots (QDs) onto the top flat surface of arrangements of SU-8 chips of all shapes and sizes and the subsequent liberation of the grafted chips. The arrangements of SU-8 chips were fabricated as stated in Example 1 and were initially functionalized with a reactive surface with selected epoxy-silane cross-linker. Subsequently amino-functionalized QDs with a fluorescence emission at 545 nm (QD545) were grafted onto an arrangement of Aspect Ratio SU-8 chips (FIG. 9a) and amino-functionalized QDs with a fluorescence emission at 525 nm (QD525) were grafted onto an arrangement of Fiducial SU-8 chips (FIG. 9c). Both grafting processes were accomplished via microcontact printing. Afterwards, the grafted arrangements of chips were liberated from the substrate with the mounting media following the process established in Example 3.

The normalized fluorescence emission of the liberated chips suspended in an aqueous medium demonstrate a uniform QD surface coverage, with small fluorescence emission dispersion and condensed emission intensities, as demonstrated in FIG. 9b and FIG. 9d. The fluorescence emission provides an individual signature that can be used to differentiate between subpopulations of liberated suspended SU-8 chips, each subpopulation grafted with a different QD. The efficiency of the signature is linked to the ability to discriminate one grafted SU-8 chip from the other. Collectively, the potential of the technology allows to obtain precise and reproducible QD patterns throughout the top surfaces of the SU-8 chips and the mild liberation process demonstrate the conservation of the customized physical and chemical traits on the top surface of the liberated SU-8 chips.

### EXAMPLE 8 Characterization of SU-8 chips grafted on their top surface with molecules or nanoparticles, the subsequent liberation of the grafted SU-8 chips, and the second fluorophore grafting of the SU-8 chips bottom surface.

The present invention establishes a pathway to endow selected surface pattern properties on the top surfaces of the SU-8 chips. This can be further expanded with the inclusion the coverage and selective printing of the bottom surface of the chips to obtain Janus chips. To fabricate these chips, we take advantage of their flush and ordered embedding into the solidified mounting medium after release established in Example 3 and their subsequent bottom patterning.

Instead of dissolving the membrane, the flat underside of the grafted SU-8 chips (7 in FIG. 1d) permits derivatizing the exposed bottom flat surfaces to create a reactive surface with selected cross-linkers (8 in FIG. 1e) and their subsequent microcontact printing whilst embedded on the solidified mounting medium to graft selected molecules and nanoparticles (9 in FIG. 1f), obtaining suspended Janus chips after dissolving the membrane (FIG. 1g).

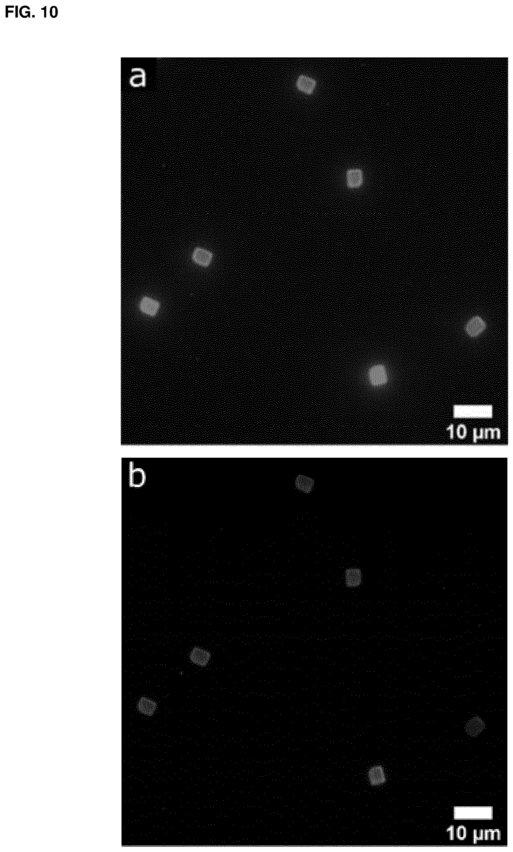

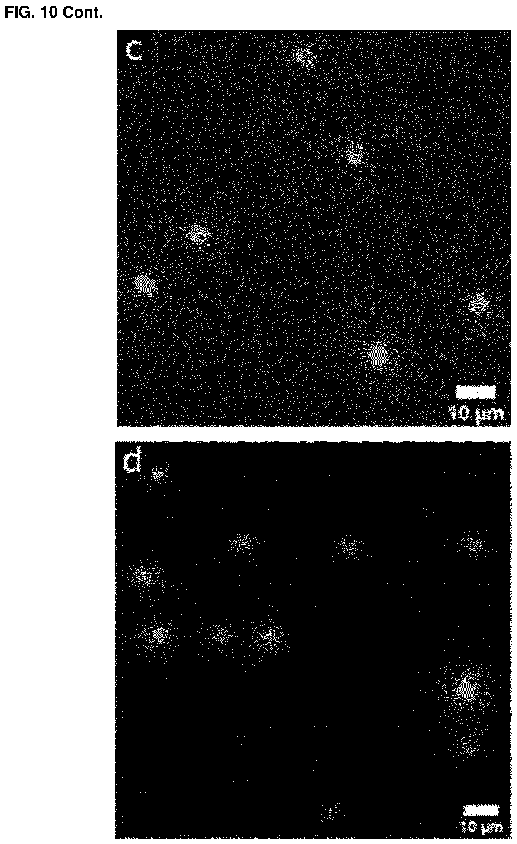

Accordingly, we initially fabricated Janus chips with two fluorophores on their opposing surfaces (FIG. 10a-c). The exposed top surface of an arrangement of Fiducial chips was functionalized with APTES (Material and Methods) to create the reactive surface and successively printed with the NHS-ester-derivatized red fluorophore with microcontact printing. After liberating the chips following the process in Example 3, the bottom surface was also amino-derivatized to create a reactive surface on the bottom surface of the chips and subsequently printed with the NHS-ester-derivatized green fluorophore with microcontact printing. The red and green fluorescence channels (FIG. 10a,b, respectively) show the resulting chips with the individual contribution of each fluorophore after dissolving the membrane and resuspended the chips in an aqueous medium. The composite image formed by the combination of the previous two images in FIG. 10c clearly describes the position of the red and green fluorescent emissions localized on the top and bottom surfaces of the suspended chips.

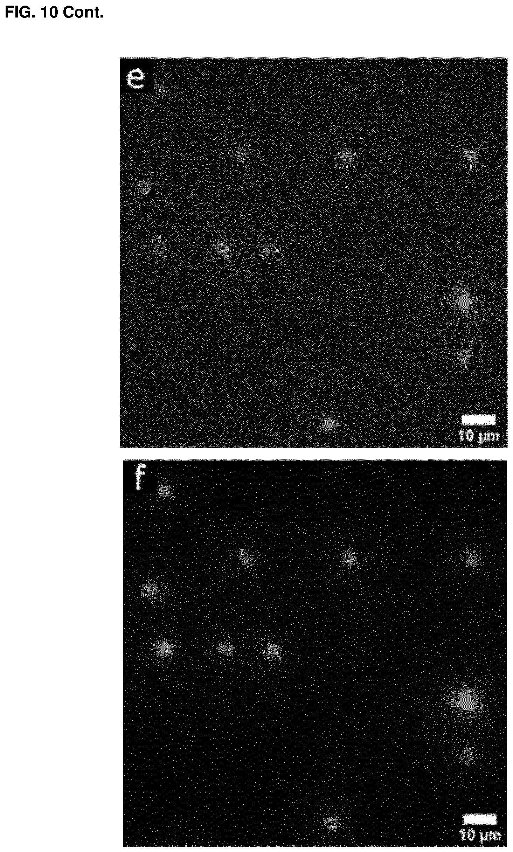

Similarly, the strategy allows the usage of different covalent bonding mechanisms to add specific traits on the top and bottom surfaces of the chips. In the present invention, an arrangement of Faceting SU-8 chips was modified with an epoxy-silane (Materials and Methods) to create a reactive surface on the top surface of the chips. Then, an amino-modified QD with fluorescence emission at 655 nm (QD655) was grafted with microcontact printing. After the arrangement of chips was liberated following the steps shown in Example 3, the now exposed bottom flat surface of the chips can be modified with an amine-bearing crosslinker to create a reactive surface for a subsequent patterning of green NHS-ester-derivatized and amine-reactive fluorophore. The red fluorescent image in FIG. 10d shows the emission of the QD655 and the green fluorescent emission in FIG. 10e shows the emission of the green-emitting fluorophore. The composite image (FIG. 10f) shows the combination of the two previous fluorescence emissions and demonstrates the localization of the QD655 and green-emitting fluorophore on each chip.

This multi-chemistry protocol allows to guide the bonding pathways to obtain Janus chips with chemically-interfering entities.

### EXAMPLE 9 Characterization of double-height SU-8 chips grafted on their top surface with nanoparticles, the subsequent liberation of the grafted SU-8 chips, and the second grafting of nanoparticles on the SU-8 chips bottom surface.

The physical traits present in the double-height SU-8 chips can be exploited to form physical constrains on the top and bottom surface areas for further chemical patterns. As shown previously in Example 2, these chips have a top surface with features at two distinctive heights, thus the patterning occurs only over the raised features. Molecules (Example 5), biomolecules (Example 6), and nanoparticles (Example 7) can be patterned via soft lithography like microcontact printing or polymer pen lithography can be patterned over those areas. Moreover, the present invention establishes the means to liberate the patterned double-height chips as described in Example 3, and add functional groups to the now exposed bottom flat surface, to form a reactive surface with selected cross-linkers as demonstrated in Example 8. This bottom flat reactive surface can be patterned with molecules (Example 5), biomolecules (Example 6), and nanoparticles (Example 7) with microcontact printing.

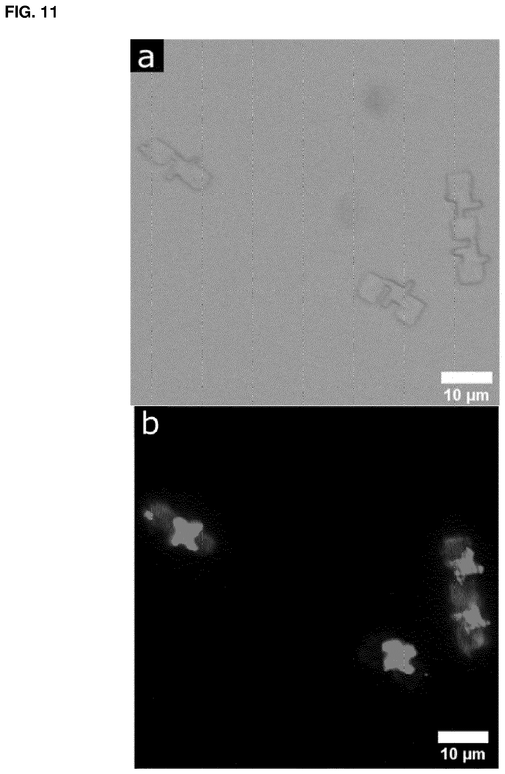

An optical microscopy image of the features of the double-height chips is shown in FIG. 11a, fabricated with an initial layer consisting of an arrangement of Fiducial SU-8 chips and the second layer of Branching SU-8 chips, following the procedure detailed in Example 2. Then, the top flat surface of the arrangement of double-height chips was functionalized to endow a reactive surface with an epoxy-silane (Materials and Methods). Microcontact printing was later used to graft amino-functionalized QD655 onto the reactive top flat surface of the double-height chips, as detailed in Example 7. The double-height chips were liberated with the mounting medium following the steps detailed in Example 3. Then, the bottom flat surface of the chips embedded in the mounting media matrix was modified with an epoxy-silane to form the reactive surface where amino-functionalized-QD545 were subsequently patterned with microcontact printing.

The fluorescence microscopy image in FIG. 11b produces a clear assessment of the suspended chips with QD655 initially printed onto the branching side of the chip and a successive epoxy derivatization and QD545 printing on the fiducial part after liberation. The fluorescence emission indicates the correct shape and size of the selective patterning of QDs initially over the top surface and subsequently over the exposed bottom surface of the chips after liberation.

Altogether, a vast array of potential Janus chips can be obtained with the present invention. Simultaneously, the chips could be patterned using selected (bio)chemical or nanoparticle-based inks to obtain surface chemical anisotropies dictated by the initial physical properties without the need of a customized stamp. Furthermore, excluding the necessity of orthogonal chemistry to create multiplexed surfaces, paves the way for multi-chemistry functionalization in a single chip.

### EXAMPLE 10 Application of suspended SU-8 chips grafted with a pH-sensing fluorophore for the determination of pH

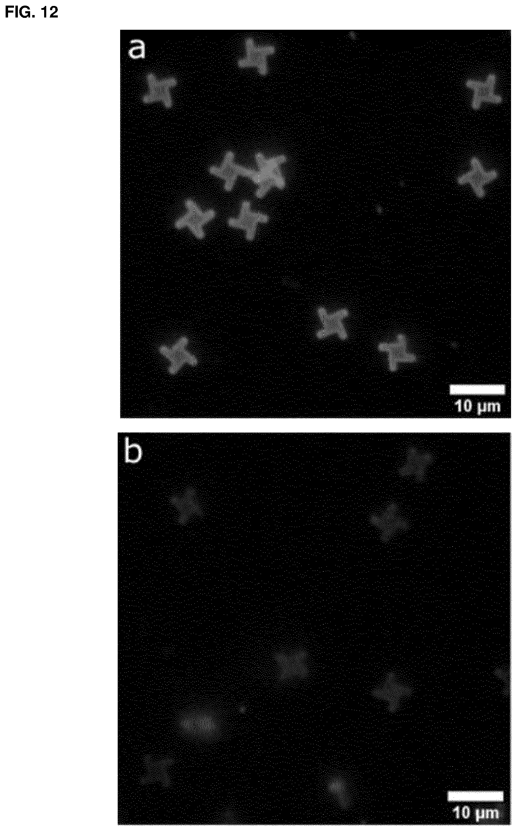

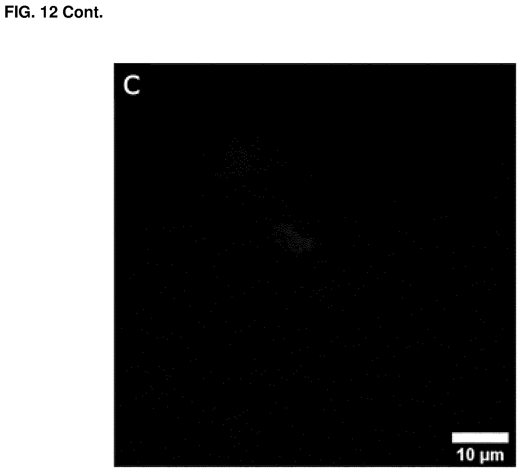

We designed a miniaturized sensing device with a customized shape and size and coupled it with sensing capabilities at the microscale. The devices consisted in an arrangement of branching chips derivatized with APTES (Materials and Methods) to form the reactive top surface. Subsequently, pHrodo^{™} Red, succinimidyl was grafted with microcontact printing onto the reactive surface. Then, the chips were liberated as stated in Example 3 and were later exposed to environments at different pH (FIG. 12). The pH-sensing fluorophore pHrodo red increases its emission at low pH values; consequently, it was observed a 4-fold increase in fluorescence at a low pH (FIG. 12a) compared to the neutral environment (FIG. 12b). The opposite occurred at a high pH were the fluorescence was negligible (FIG. 12c), consequently, the fluorescence of the chips is not visible.

The detailed physical anisotropy for ease of identification could be extrapolated towards multiplexed studies using the same fluorescence emission wavelength in suspended chips with their customized physical attributes, and, due to their size in extraordinarily small volumes.

### EXAMPLE 11 Application of suspended SU-8 chips grafted with a sensing biomolecule on the top surface and a fluorescent label on the bottom surface

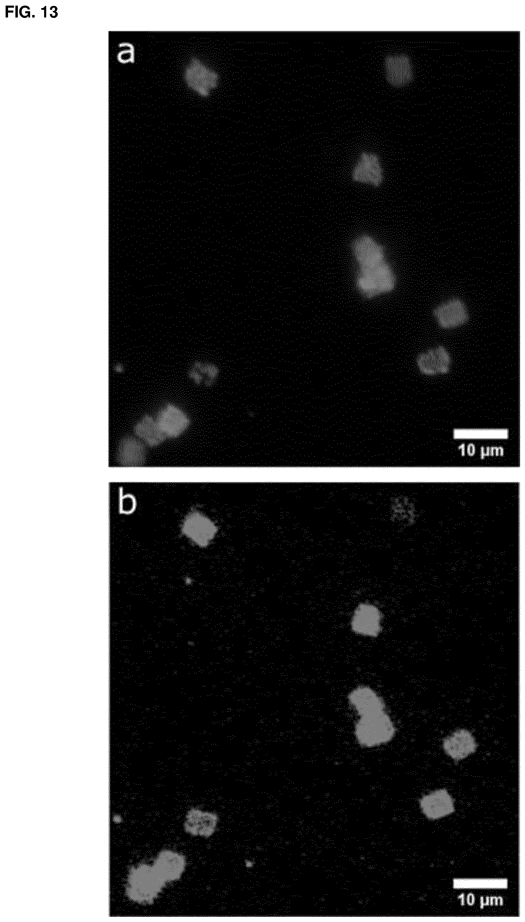

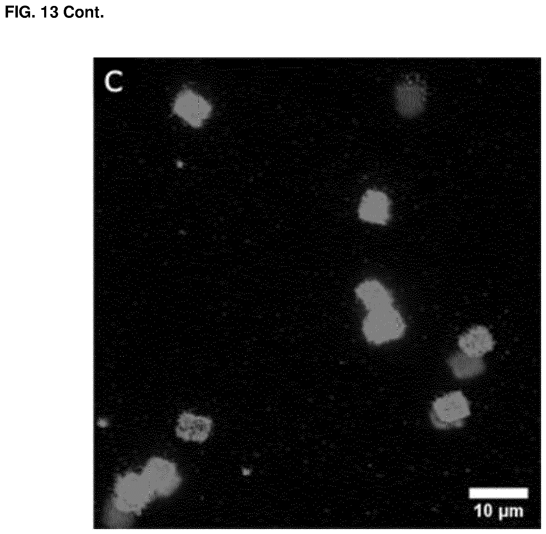

The present invention demonstrates the detection capability by performing a single step bioassay that consists in a Janus chip with a sensing face on the top surface of the chip and a complementary labelled face on the bottom surface of the chip. The chip consists of a DNA-sensing face and a QD signature on the other face (FIG. 13).

An arrangement of Fiducial chips was first modified with the epoxy-silane (Materials and Methods) to obtain a reactive top surface. Subsequently, amine-modified oligos ('probe 1') were derivatized onto the top surface with microcontact printing, following the steps detailed in Example 6. The grafted chips were later liberated with the mounting media as detailed in Example 3 and a reactive surface was endowed on the bottom face of the chips while embedded in the mounting media with APTES (Materials and Methods). Then, amino-derivatized QD655 was printed onto the reactive bottom surface with microcontact printing following the steps in Example 9. The mounting media was later dissolved and the suspended chips were then incubated with a probe ('probe 2') modified with a green-emitting fluorescent marker complementary to `probe1' with a perfect base-pair match to promote hybridization. The suspended chips with the hybridized 'probe2' were washed, and lastly recollected via centrifugation.

The chips are visible with the QD655 grafted onto the bottom surface and is used as a label to identify the chips (FIG. 13a).

The analysis of the bioassay with fluorescent microscopy, shows the targeting of 'probe2' towards the printed `probe1' resulting in a green emission signature (FIG. 13b).

This could offer a great advantage in DNA coded recognition with suspended devices in a multiplexed subpopulation. This approach can use different QDs to create independent fluorescent signatures for a population of chips derivatized with unique DNA sequences and cDNA strands all labelled with the same fluorophore, thus, eliminating the drawbacks present with the limited available fluorophores for DNA labelling.

### EXAMPLE 12 Application towards the creation of barcoding libraries with suspended SU-8 chips.

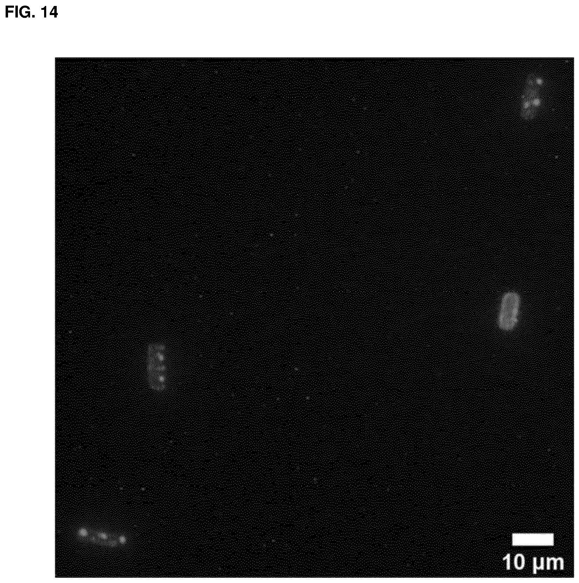

The present invention demonstrates Janus multiplexed chips combining multi-chemistry and surface pattern designs, coupled with a fiducial mark for correct code reading, for barcoding at extremely small volumes. An arrangement of Aspect ratio SU-8 chips was derivatized with APTES (Materials and Methods) to endow a reactive moiety onto the top surface of the chips. Then, NHS-ester-derivatized and amine-reactive fluorophores were grafted with polymer pen lithography creating discreet fluorescence-emitting spots on the top surface of the arrangement of SU-8 chips. The color emission and the position of the spots create the coding elements of the barcode. The arrangement of chips is later liberated with the mounting medium as explained in Example 3 and the exposed bottom surface of the embedded chips was functionalized with an epoxy-silane (Materials and Methods) to create a reactive surface. Then, microcontact printing is used to graft amino-modified QD655 onto the reactive bottom surfaces of the chips. QDs were printed in this case for easy identification of the chips, yet can be substituted by any sensing molecule or nanoparticle. The solidified mounting medium is later dissolved in an aqueous medium to obtain the suspended chips (FIG. 14).

A numerical value can be assigned to the coding area: a red fluorophore spot with the value 2, the green fluorophore spot with the value 1 and an empty space represented a 0 of a ternary coding system.

Color-barcoded chips have demonstrated 6 coding features (m) in a total volume of ~0.63×106 µm3 with up to 9 different colors (n), with a theoretical encoding density calculated by nm/V of -0.8 codes µm-3. This density can be expanded by augmenting the chip size to increase the number of coding features. Such approach is used in other reported chips containing 10 coding features in a volume of ~4.8×106 µm3 coupled with 8 different colors, thus a calculated 223 codes µm-3. The great barcoding potential of these chips is limited in applications that require further miniaturization, where the present invention could present a valid alternative. Interestingly, the parallel patterning coupled with just two different fluorophores in 9 possible spots, the 18 µm3 Aspect Ratio chips could be coded to obtain a calculated coding density of 1,093 codes µm-3 in a small volume. Consequently, these coded Janus chips expand their outreach by adding a bottom layer which does not interfere with the multiplexed planar array and can be subsequently used to expand the functionality or be used for increased barcoding.

## Claims

1. A process for the obtainment of suspended double-flat SU-8 Janus chips comprising:
• a plurality of double-flat SU-8 chips, wherein each SU-8 chip has a first flat surface and a second flat surface,
• and molecules, biomolecules, nanoparticles or a combination thereof,
wherein said molecules, biomolecules, nanoparticles or the combination thereof are grafted onto the first and the second flat surface of each SU-8 chip, and wherein
• the molecules are preferably selected from the list consisting of modified chromophores comprising N-Hydroxysuccinimidyl ester or Succinimidyl ester groups and modified fluorophores comprising N-Hydroxysuccinimidyl ester or Succinimidyl ester groups,
• the biomolecules are preferably selected from the list consisting of carbohydrates, proteins, antibodies, enzymes and nucleic acids, and
• the nanoparticles are preferably selected from carbon-based nanoparticles comprising an amine functional group, metal nanoparticles comprising an amine functional group, ceramic nanoparticles comprising an amine functional group, polymeric nanoparticles comprising an amine functional group and semiconductor nanoparticles comprising an amine functional group;
said process **characterised in that** it comprises the following steps:
a) defining the shape and the size of SU-8 chips by means of SU-8 photolithography; thereby forming an arrangement of ordered SU-8 chips onto a substrate, wherein each SU-8 chip has a first flat surface and a second flat surface and wherein the second flat surface is in direct contact with the substrate;
b) functionalizing, by means of soft lithography, the first flat surface of each SU-8 chip obtained in step (a) using a silane crosslinker; thereby forming a first reactive flat surface in each SU-8 chip, wherein the silane crosslinker comprises two functional groups:
• a silane functional group and
• a functional group selected from the list consisting of primary or secondary amines, epoxide, thiol, carboxyl, azide, vinyl, isocyanate or methacryloxy groups;
c) grafting molecules, biomolecules, nanoparticles or a combination thereof onto the first reactive flat surface of each SU-8 chip obtained in step (b) by means of soft lithography;
d) casting a mounting medium on top of the SU-8 chips obtained in step (c) and leaving to solidifying, thereby embedding the SU-8 chips obtained in step (c) into the mounting medium and forming a solidified membrane onto the substrate;
e) peeling off the solidified membrane obtained in step (d) from the substrate, thereby unlocking the second flat surface of each SU-8 chip;
f) functionalizing, by means of soft lithography, the unlocked second flat surface of each SU-8 chip obtained in step (e) using a silane crosslinker, wherein the silane crosslinker comprises two functional groups:
• a silane functional group and
• a functional group selected from the list consisting of primary or secondary amines, epoxide, thiol, carboxyl, azide, vinyl, isocyanate or methacryloxy groups; thereby forming a second reactive surface in each SU-8 chip;
g) grafting molecules, biomolecules, nanoparticles or a combination thereof onto the second reactive surface of each SU-8 chip obtained in step (f) by means of soft lithography;
h) dissolving the solidified membrane of the SU-8 chips obtained in step (g) in an aqueous medium; and
i) recollecting the suspended double-flat SU-8 Janus chips obtained in step (h) via centrifugation.

2. The process according to claim 1, wherein step (a) can be repeated thereby obtaining a double-height arrangement of ordered SU-8 chips on the substrate.

3. The process according to any of claims 1 or 2, wherein steps (b) and (c) can be repeated.

4. The process according to any of claims 1 to 3, wherein the molecules, biomolecules or nanoparticles grafted onto the first flat surface of each SU-8 chip obtained in step (c) comprises only one type of molecules, biomolecules or nanoparticles grafted onto the first flat surface of each SU-8 chip; thereby forming a first planar printed arrangement.

5. The process according to any of claims 1 to 3, wherein the molecules, biomolecules or nanoparticles grafted onto the first flat surface of each SU-8 chip obtained in step (c) comprises the combination of molecules, biomolecules or nanoparticles grafted onto the first flat surface of each SU-8 chip; thereby forming a first planar array.

6. The process according to any of claims 1 to 5, wherein soft lithography of steps (b) and (c) is performed in the form line patterns and/or spots.

7. The process according to any of claims 1 to 6, wherein steps (f) and (g) can be repeated.

8. The process according to any of claims 1 to 7, wherein the molecules, biomolecules or nanoparticles grafted onto the second flat surface of each SU-8 chip obtained in step (g) comprises only one type of molecules, biomolecules or nanoparticles grafted onto the second flat surface of each SU-8 chip; thereby forming a second planar printed arrangement.

9. The process according to any of claims 1 to 7, wherein the molecules, biomolecules or nanoparticles grafted onto the second flat surface of each SU-8 chip obtained in step (g) comprises the combination of molecules, biomolecules or nanoparticles grafted onto the second flat surface of each SU-8 chip; thereby forming a second planar array.

10. The process according to any of claims 1 to 9, wherein soft lithography of steps (f) and (g) is performed in the form line patterns and/or spots.

11. Suspended double-flat Janus chips, preferably obtained by the process according to any of claims 1 to 10, **characterized in that** they comprise:
• a plurality of double-flat SU-8 chips, wherein each SU-8 chip has a first flat surface and a second flat surface,
• and molecules, biomolecules, nanoparticles or a combination thereof,
wherein said molecules, biomolecules, nanoparticles or the combination thereof are grafted onto the first and the second flat surface of each SU-8 chip.

12. Suspended double-flat Janus chips according to claim 11, wherein the molecules are selected from the list consisting of modified chromophores comprising N-Hydroxysuccinimidyl ester or Succinimidyl ester groups and modified fluorophores comprising N-Hydroxysuccinimidyl ester or Succinimidyl ester groups.

13. Suspended double-flat Janus chips according to any of claims 11 or 12, wherein the biomolecules are selected from the list consisting of carbohydrates, proteins, antibodies, enzymes and nucleic acids.

14. Suspended double-flat Janus chips according to any of claims 11 to 13, wherein the nanoparticles are selected from carbon-based nanoparticles comprising an amine functional group, metal nanoparticles comprising an amine functional group, ceramic nanoparticles comprising an amine functional group, polymeric nanoparticles comprising an amine functional group and semiconductor nanoparticles comprising an amine functional group.

15. Suspended array **characterized in that** it comprises at least two different suspended double-flat Janus chips according to any of claims 11 to 14.

16. A process for the obtainment of the suspended array according to claim 15 **characterized in that** it comprises a step of mixing at least two different suspended double-flat Janus chips.

17. Barcoding chip **characterized in that** it comprises the suspended double-flat Janus chips according to any of claims claim 11 to 14 or the suspended array according to claim 15.

18. Barcoding chip according to claim 17, said barcoding chip is a color barcoding chip, wherein at least a nanoparticle is grafted on the first or the second flat surface of each SU-8 chip in the form of line patterns and/or spots and said nanoparticle is an amine-modified Quantum Dot.

19. Sensing device **characterized in that** it comprises the suspended double-flat Janus chips according to any of claims 11 to 14 or the suspended array according to claim 15.

20. Sensing device according to claim 19, said sensing device is a pH sensing device, wherein at least a molecule is grafted on the first or the second flat surface of each SU-8 chip, said molecule is a pH sensing fluorophore comprising N-Hydroxysuccinimidyl ester or Succinimidyl ester groups.

21. Sensing device according to claim 19, said sensing device is DNA sensing device, wherein at least a biomolecule is grafted on the first or the second flat surface of each SU-8 chip, said biomolecule is a DNA probe.
